# EUROPEAN PATENT SPECIFICATION

(11) **EP 3 955 714 B1**
(45) Date of publication and mention of the grant of the patent: **23.08.2023**
(21) Application number: 20832821.1
(22) Date of filing: 17.06.2020
(51) Int. Cl.: H05K 5/02, B44C 5/04, B44C 3/02, H04M 1/02, C09D 11/037

(54) **HOUSING ASSEMBLY AND PREPARATION METHOD THEREOF, AND ELECTRONIC DEVICE**
GEHÄUSEANORDNUNG UND HERSTELLUNGSVERFAHREN DAFÜR SOWIE ELEKTRONISCHE VORRICHTUNG
ENSEMBLE BOÎTIER ET SON PROCÉDÉ DE PRÉPARATION, ET DISPOSITIF D'AFFICHAGE

(30) Priority: 27.06.2019 CN 201910568849
(43) Date of publication of application: 16.02.2022
(73) Proprietor: GUANGDONG OPPO MOBILE TELECOMMUNICATIONS CORP., LTD., Dongguan, Guangdong 523860 (CN)
(72) Inventor: WU, Xin, Dongguan, Guangdong 523860 (CN); BI, Sipeng, Dongguan, Guangdong 523860 (CN); HOU, Tibo, Dongguan, Guangdong 523860 (CN)
(74) Representative: Manitz Finsterwald Patent- und Rechtsanwaltspartnerschaft mbB
(86) International application number: PCT/CN2020/096476
(87) International publication number: WO 2020/259359

(56) References cited:
- WO-A1-2019/003570
- CN-U- 205 705 588

## Description

### FIELD

The present disclosure relates to a field of electronic devices, and more particularly to a housing assembly and a fabrication method thereof, and an electronic device.

### BACKGROUND

With the development of electronic device fabrication technology, various materials are used for housings of the electronic devices. As the material of glass has a good light transmittance, corrosion resistance and heat resistance, and is easy to be fabricated, and the decorative membrane is easy to be fabricated, and has a low cost and various appearances, the housing of electronic device made of a transparent base and a decorative membrane is widely used. For example, a diversified appearance of a battery back housing of a mobile phone may be achieved by attaching a membrane to a glass housing.

CN 205 705 588 U discloses a non-planar tempered glass with a textured decoration, including a glass base, a solid optical adhesive layer, a solid optical decoration layer, a coating layer and a light-shielding layer. The solid optical adhesion layer is disposed on an inner surface of the glass base.

WO 2019/003570 A1 discloses a decorative glass panel including a glass substrate having at least a part of one surface as a curved surface, an uneven pattern layer formed on one surface of the glass substrate and having an uneven pattern on the upper surface, and a metal vapor deposition layer formed on the upper surface of the uneven pattern layer.

Nevertheless, the existing housing assembly and the fabrication method thereof, and the electronic device still need to be improved.

### SUMMARY

The invention is set out in the appended set of claims.

In a first aspect of the present disclosure, a housing assembly is provided. The housing assembly includes: a housing base being transparent and having a bottom surface and a sidewall connected to the bottom surface, and an appearance membrane located on a side of the housing base. A bending angle between the sidewall and the bottom surface is greater than 70 degrees. The appearance membrane includes a soft substrate, and a glossy silver layer located on a side of the soft substrate. The soft substrate has an elastic modulus in a range of 800Mpa to 2000Mpa, and the soft substrate includes at least one of a thermoplastic polyurethane, a polyvinyl chloride, and a thermoplastic elastomer. In this way, the housing assembly has a large radian, and the appearance membrane and the housing base are firmly bonded/attached, and thus the housing assembly has a good appearance effect and a high expressiveness. For example, a metallic luster effect may be achieved without coating a metal film.

In a second aspect of the present disclosure, a method for fabricating a housing assembly is provided. The method includes: providing a housing base being transparent and having a bottom surface and a sidewall connected to the bottom surface; and forming an appearance membrane, and bonding the appearance membrane on a side of the housing base. A bending angle between the sidewall and the bottom surface is greater than 70 degrees. Forming the appearance membrane includes: providing a soft substrate, and forming a glossy silver layer on a side of the soft substrate. The soft substrate has an elastic modulus in a range of 800Mpa to 2000Mpa, and the soft substrate includes at least one of a thermoplastic polyurethane, a polyvinyl chloride, and a thermoplastic elastomer. In this way, the housing assembly fabricated by the method has a large radian, and the appearance membrane and the housing base are firmly bonded/attached, and thus the housing assembly has a good appearance effect and a high expressiveness. For example, a metallic luster effect may be achieved without coating a metal film.

In a third aspect of the present disclosure, an electronic device is provided. The electronic device includes: the above-mentioned housing assembly in the first aspect or the housing assembly fabricated by the above-mentioned method in the second aspect, a mainboard and a memory, and a screen. An accommodating space is defined by the housing assembly, and the appearance membrane of the housing assembly faces toward an interior of the electronic device. The mainboard and the memory are located inside the accommodating space. The screen is located on a top of the housing assembly and connected to the mainboard. In this way, the electronic device has all the features and advantages of the above-mentioned housing assembly in the first aspect or the housing assembly fabricated by the above-mentioned method for fabricating the housing assembly in the second aspect, which will not be repeated here. In general, the electronic device has a good appearance and a high expressiveness.

### BRIEF DESCRIPTION OF THE DRAWINGS

FIG. 1 is a schematic diagram showing a housing assembly according to an embodiment of the present disclosure.
FIG. 2 is a schematic diagram showing a housing base according to an embodiment of the present disclosure.
FIG. 3 is a schematic diagram showing a partial cross-sectional structure of a housing assembly according to an embodiment of the present disclosure.
FIG. 4 is a schematic diagram showing a partial cross-sectional structure of a housing assembly according to another embodiment of the present disclosure.
FIG. 5 is a schematic diagram showing a partial cross-sectional structure of a housing assembly according to still another embodiment of the present disclosure.
FIG. 6 is a schematic diagram showing a partial cross-sectional structure of a housing assembly according to yet another embodiment of the present disclosure.
FIG. 7 is a flowchart of a method for fabricating a housing assembly according to an embodiment of the present disclosure.
FIG. 8 is a flowchart of a method for fabricating an appearance membrane according to an embodiment of the present disclosure.
FIG. 9 is a flowchart of a method for fabricating an appearance membrane according to another embodiment of the present disclosure.
FIG. 10 is a flowchart of a method for fabricating an appearance membrane according to still another embodiment of the present disclosure.
FIG. 11 is a schematic diagram showing an electronic device according to an embodiment of the present disclosure.

Reference numerals:
100: housing base; 110: bottom surface; 120: sidewall; 200: appearance membrane; 210: soft substrate; 220: color layer; 240: textured layer; 230: glossy silver layer; 250: covering layer; 1000: housing assembly; 1100: electronic device.

### DETAILED DESCRIPTION

The embodiments of the present disclosure are described in detail below. Examples of the embodiments are shown in the accompanying drawings. The following embodiments described with reference to the drawings are illustrative and used to explain the present disclosure.

The present disclosure is based on the findings and the recognitions of the following facts and problems.

It is found that when a transparent base with a relatively large bending angle is used for fabricating a housing of an electronic device, it is difficult to bond/attach an appearance membrane to the transparent base. Currently, when an electronic device housing is fabricated by a combination of the transparent base and the appearance membrane, polyethylene terephthalate membrane (PET membrane) is generally used as a substrate material for the appearance membrane due to its high hardness and scratch resistance. Further, on the PET membrane a textured layer may be transfer printed, a metal layer may be electroplated, and an ink layer may be printed, to make the appearance membrane have a diversified appearance. Then the appearance membrane is bonded to the transparent base. However, in the above-mentioned method for fabricating the electronic device housing, the transparent base usually has a small bending angle. For example, a common 3D glass cover plate has a relatively limited bending angle. When the appearance membrane is bonded/attached to the transparent base, the PET membrane and the laminated materials (such as, the above-mentioned textured layer, the metal layer, the ink layer, etc.) on the PET membrane will not be significantly stretched, and therefore the above-mentioned appearance membrane with the PET membrane as the substrate material may be well bonded to the transparent base to achieve a good appearance. However, it is difficult for the PET membrane to be bonded to a transparent base with a relatively large bending angle, for example a glass back housing having a radian angle of more than 30° with respect to all four sides, since the PET membrane has an elastic modulus of more than 4000Mpa, a high hardness, and a poor flexibility. During the bonding process, bubbles and cracks of laminated materials may occur, which affects the appearance expressiveness of the housing. Thereby, disclosure of the transparent base (for example of a glass material) having a relatively large bending angle are limited in the electronic device housings. On this basis, in order to solve the above-mentioned problems in the art, a new housing assembly having a good appearance, in which the appearance membrane may be firmly bonded to the housing base bent with a large angle, is needed.

Embodiments of the present disclosure are at least meant to solve at least one of the problems existing in the related art to some extent.

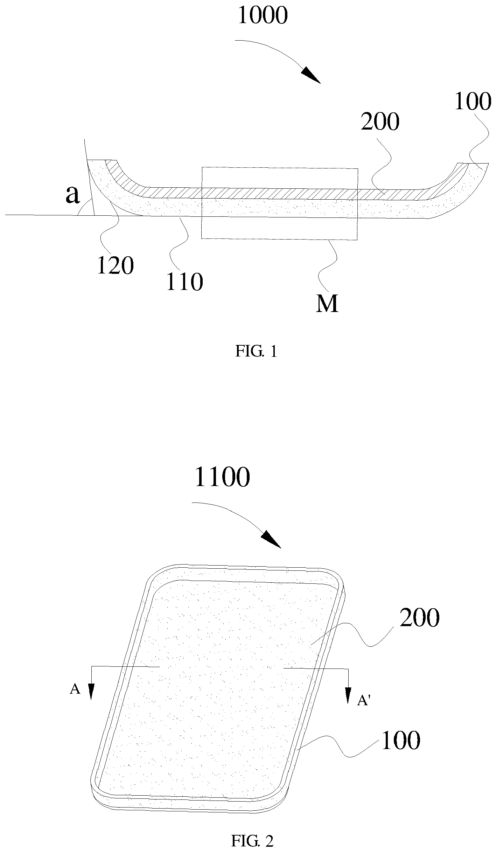

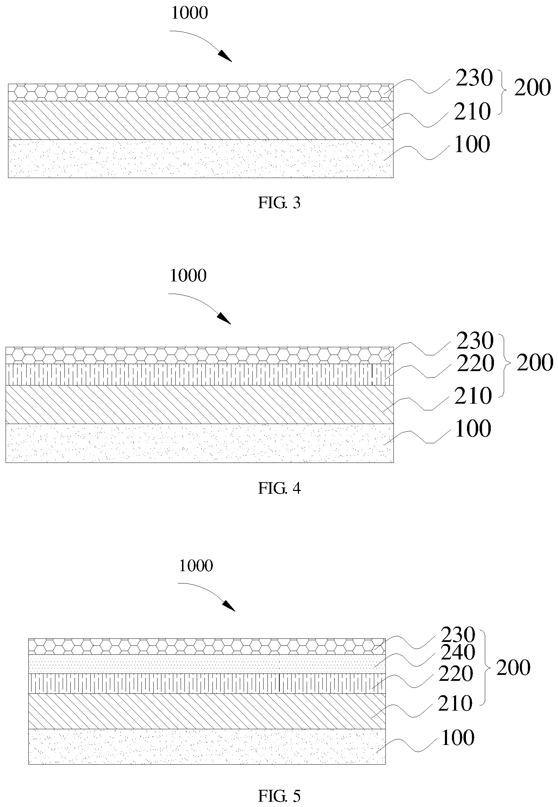

In a first aspect of the present disclosure, a housing assembly is provided. In an embodiment of the present disclosure, as shown in FIG. 1, the housing assembly 1000 includes a housing base 100 and an appearance membrane 200. The appearance membrane 200 is located on a side of the housing base 100. As shown in FIG. 1 and FIG. 2, the housing base 100 has a bottom surface 110 and a sidewall 120 (for example, two sidewalls 120 oppositely arranged as shown in FIG. 1, or four sidewalls 120 connected to each other as shown in FIG. 2) connected to the bottom surface 110. A bending angle (bending angle *a* as shown in FIG. 1) between the sidewall 120 and the bottom surface 110 is greater than 70 degrees. As shown in FIG. 3 (showing a cross-sectional structure of a region M of FIG. 1), the appearance membrane 200 includes a soft substrate 210 and a glossy silver layer 230. The glossy silver layer 230 is located on a side of the soft substrate 210. The soft substrate 210 has an elastic modulus in a range of 800Mpa to 2000Mpa. In this way, the soft substrate 210 has a relatively small elastic modulus, and a good flexibility. The housing assembly 1000 has a large radian, and the appearance membrane 200 and the housing base 100 are firmly bonded. In this case, the housing assembly 1000 has a good appearance effect. A metallic luster effect can be achieved by the glossy silver layer 230 without coating a metal film. Moreover, the housing assembly 1000 has an improved luminance and product expressiveness.

It should be noted that the term "bending angle" in the present disclosure refers to an angle (angle *a* shown in FIG. 1) between the sidewall 120 and the bottom surface 110. Specifically, the bottom surface 110 may be a flat or curved surface; specifically, the bending angle is an angle between the sidewall and a plane where the bottom surface resides. When an outer surface (a surface away from the appearance membrane 200) of the sidewall 120 is a flat surface, the bending angle is an angle between the bottom surface 110 and a plane where the outer surface of the sidewall 120 is located. When the outer surface of the sidewall 120 is a curved surface, the bending angle between the sidewall 120 and the bottom surface 110 is a maximum angle between a tangent at any point of the curved surface and the plane where the bottom surface 110 is located. When the bottom surface 110 is a curved surface, the bending angle between the sidewall 120 and the bottom surface 110 is an angle between the sidewall 120 and a tangent plane of the bottom surface 110. As mentioned above, the housing base 100 may have four sidewalls 120, and the bending angles between the four sidewalls 120 and the bottom surface 110 may be the same or different. For example, among the four sidewalls, a bending angle between a sidewall and the bottom surface may be equal to a bending angle between an opposite sidewall and the bottom surface, and may be different from a bending angle between an adjacent sidewall and the bottom surface.

For better understanding, the reasons that the housing assembly according to embodiments of the present disclosure is capable of achieving the above-mentioned technical effects are described as follows.

As mentioned above, when the transparent glass base and the appearance membrane with color and pattern are bonded to fabricate the electronic device housing, since the glass base has a small bending angle, the existing PET membrane can be firmly bonded to the glass base to achieve a good appearance. However, when the housing base (e.g., glass) has a large bending angle, the PET membrane is difficult to be bonded to the housing base with the large bending angle (e.g., greater than 30 degrees) due to its high rigidity and poor ductility. In the present disclosure, a soft substrate having the relatively small elastic modulus (in a range of 800Mpa to 2000Mpa) is used as the substrate of the appearance membrane to fabricate the housing assembly. Since the soft substrate has a good flexibility, it can be firmly bonded to the housing base with a large bending angle without the problem of bubbles. Moreover, the inventors have conducted intensive researches, and obtained the following findings. When a coating layer is formed on the soft substrate by a common coating way (to achieve the metallic luster effect for the housing assembly), the bonding force between the coating layer and the soft substrate is poor due to the softness of the soft substrate and the hardness and fragility of materials (usually being metal oxides) of the coating layer. In addition, when the appearance membrane is bonded to the base having the large bending angle, the coating layer is prone to crack, affecting the appearance of the housing assembly. In the housing assembly of the present disclosure, the glossy silver layer is located on the side of the soft substrate away from the housing base. The glossy silver layer may be formed by a simple process, such as by screen printing. In this way, the housing assembly may have the metallic luster effect by printing the glossy silver layer, etc., without coating the metal film, which improves the luminance of the housing assembly and the expressiveness of the product. Moreover, a bonding force between the glossy silver layer and the soft substrate may be strong. In this case, the glossy silver layer has a high cracking resistance when the appearance membrane is bonded to the housing assembly having the large bending angle, thereby achieving a high product yield and a good appearance.

In some embodiments of the present disclosure, specific types of the housing assembly 100 are not specially limited, and may be glass, for example. Specifically, the bottom surface 110 may be a flat or curved surface. Specifically, as shown in FIG. 1 and FIG. 2, the housing base 100 has one bottom surface 110 and the sidewall(s) 120 connected to the bottom surface 110. Specifically, the housing base 100 may have four sidewalls 120 that surround the bottom surface 110 and are connected to each other. The bending angle (the bending angle *a* as shown in FIG. 1) between the sidewall 120 and the bottom surface 110 is greater than 70 degrees. For example, the bending angle *a* between the sidewall 120 and the bottom surface 110 may be 80 degrees, 90 degrees, 100 degrees, 120 degrees or 130 degrees. That is, the sidewall 120 may be perpendicular to the bottom surface 110 (i.e., the bending angle *a* is 90 degrees), or may be bent toward inside of the housing base 100 (i.e., the bending angle *a* is greater than 90 degrees). In addition, the four sidewalls 120 of the housing base 100 may all be bent at a large bending angle. Therefore, the housing assembly 100 may have a diversified appearance and an improved product expressiveness. Specifically, the soft substrate 210 has an elastic modulus in the range of 800Mpa to 2000Mpa, such as, 1000MPa, 1200MPa, 1500MPa or 1800MPa. Compared with the PET membrane with an elastic modulus up to 4000Mpa, the soft substrate has a better flexibility, a better ductility, and a better curved surface adaptability, and may be conveniently and closely bonded to the glass base having a large curvature at its four sides. The housing assembly as fabricated may have a good appearance. Specifically, the soft substrate 210 includes at least one of a thermoplastic polyurethane (TPU), a polyvinyl chloride (PVC), and a thermoplastic elastomer. The thermoplastic elastomer may be a linear triblock copolymer, styrene ethylene butylene styrene (SEBS) with polystyrene as a terminal block and an ethylene-butene copolymer (which is obtained by hydrogenating polybutadiene) as an intermediate elastic block, or may be a linear triblock copolymer, styrene ethylene isoprene styrene (SEPS) with polystyrene as a terminal block and an ethylene-isoprene copolymer (which is obtained by hydrogenating polyisoprene) as an intermediate elastic block. For example, the soft substrate 210 may be thermoplastic polyurethane. Specifically, the soft substrate 210 may have a thickness of 80µm to 100µm, such as, 85µm, 90µm or 95µm. The soft substrate 210 with the above-mentioned thickness may be closely bonded to the housing assembly 100 having a large bending angle.

In some embodiments of the present disclosure, as shown in FIG. 4, the appearance membrane 200 may further include a color layer 220, and the color layer 220 is located between the soft substrate and the glossy silver layer. That is, the color layer 220 may be located on a side of the soft substrate 210, and the glossy silver layer 230 may be located on a side of the color layer 220 away from the soft substrate 210. In this way, the color layer 220 may enhance a bonding force between the soft substrate 210 and the glossy silver layer 230, to prevent the glossy silver layer 230 from being cracked when the appearance membrane 200 is bonded/attached to the housing assembly 100 having a large bending angle, thereby achieving a high product yield and a good appearance. Specifically, the color layer 220 may be formed by screen printing a color ink on one side of the soft substrate 210. The color of the color layer 220 is not specially limited, and may be selected by those skilled in the art according to the desired color effect. For example, the color may be blue, purple, black, white, red, or pink. Specifically, the color layer 220 may have a light transmittance of 30% to 70%, such as, 35%, 50% or 65%. In this way, the color layer 220 with the above-mentioned light transmittance may be combined with the glossy silver layer 230, to make the housing assembly 1000 have a color effect and a metallic luster effect at the same time, and also have a high luminance and an improved product expressiveness. It should be noted that, as shown in FIG. 4, in the housing assembly 1000, the color layer 220 is located on the side of the soft substrate 210 away from the housing base 100, and the glossy silver layer 230 is located on the side of the color layer 220 away from the soft substrate 210. In this case, when the housing assembly 1000 is used for an electronic device (such as a mobile phone housing), the housing base 100 faces toward the user, and the glossy silver layer 230 faces toward an interior of the electronic device. Therefore, in order to enable the user to observe a superposition effect of the color layer 220 and glossy silver layer 230 from a side of the housing base 100, the color layer 220 may have a light transmittance of 30% to 70%, that is, the color layer 220 may be translucent. In this way, the color of the color layer 220 may be presented, and the metallic luster effect of the glossy silver layer 230 may also be revealed, thus improving the appearance of the housing assembly 1000.

Specifically, the color layer 220 may have a thickness of 4µm to 12µm, such as, 5µm, 7µm, 9µm or 11µm. The color layer 220 with the above-mentioned thickness may have a suitable light transmittance, to make the housing assembly 1000 have a color effect and a metallic luster effect at the same time, thereby achieving the diversified appearance. When the thickness of the color layer 220 is too small (such as, less than 4µm), the color effect is faint. When the thickness of the color layer 220 is too large (such as, more than 12µm), the light transmittance of the color layer 220 will be reduced, thereby affecting the overall appearance of the housing assembly 1000.

In some embodiments of the present disclosure, as shown in FIG. 4, the glossy silver layer 230 is located on a side of the color layer 220 away from the soft substrate 210. The glossy silver layer 230 may be formed by screen printing a glossy silver ink. Specifically, the glossy silver layer 230 may have a thickness of 2µm to 8µm, such as, 3µm, 5µm or 7µm. In this way, when the glossy silver layer 230 has the above-mentioned thickness, the housing assembly 1000 may have a good metallic luster effect, and the luminance and the appearance expressiveness of the housing assembly 1000 may be further improved. If the thickness of the glossy silver layer 230 is too small (such as, less than 2µm), the metallic effect of the glossy silver layer 230 is faint. If the thickness of the glossy silver layer 230 is too large (such as, more than 8µm), the cost is high, and the metallic luster effect will not be improved significantly.

Specifically, the housing assembly 1000 may have a luminance L of 60 to 80. In this way, the larger the luminance L of the housing assembly 1000 is, the higher the luminance is, and the better the appearance and expressiveness is. It should be noted that the luminance L ranges from 0 to 100. The larger the luminance L is, the brighter (whiter) the light is; and the smaller the L value is, the darker (more black) the light is.

In some embodiments of the present disclosure, as shown in FIG. 5, the appearance membrane 200 may further include a textured layer 240, and the textured layer 240 may be located between the color layer 220 and glossy silver layer 230. In this way, the textured layer 240 may be superimposed on the glossy silver layer 230 to realize the metallic luster effect, and diversify the appearance of the housing assembly 1000. Specifically, the textured layer 240 may have a thickness of 6µm to 12µm, such as 7µm, 9µm or 11µm. The textured layer 240 with the above-mentioned thickness may be well bonded to the glossy silver layer 230 to allow the housing assembly to have a good metallic luster effect.

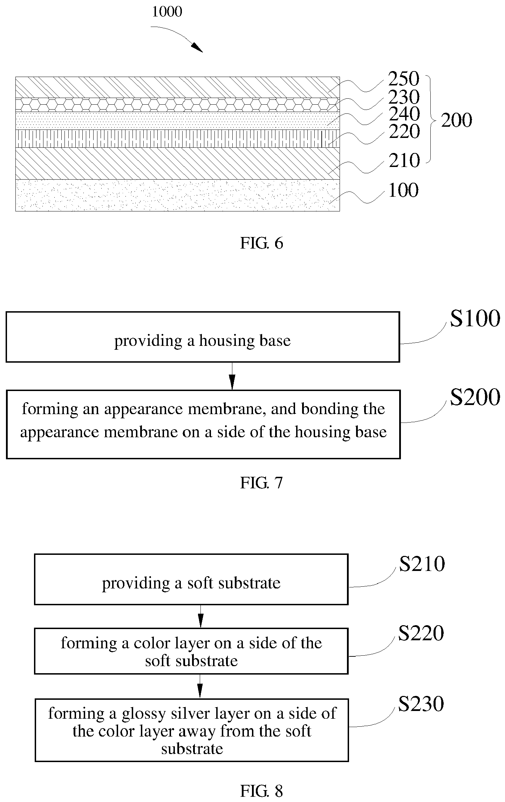

In some embodiments of the present disclosure, as shown in FIG. 6, the appearance membrane 200 may further include a covering layer 250, and the covering layer 250 is located on a side of the glossy silver layer 230 away from the color layer 220 and has a light transmittance of equal to or less than 1%. In this way, when the appearance membrane 200 is bonded/attached to the housing base 100, and is used for the housing of an electric device or the like, the appearance membrane 200 may face toward an interior of the electronic device. Furthermore, the covering layer 250 of the appearance membrane 200 is located near the interior of the electronic device, and may hide internal elements in the electronic device, thereby improving use performances of the housing assembly 1000. Specifically, a covering ink, such as black ink or white ink, may be printed on the side of the glossy silver layer 230 away from the textured layer 240 to form the covering layer 250. The covering layer 250 may have a thickness of 20µm to 30µm, such as 21µm, 23µm, 25µm, 27µm or 29µm. In this way, the covering layer 250 with the above-mentioned thickness may well hide the internal elements of the electronic device, thereby further improving the use performances of the housing assembly 1000, and achieving the diversified appearance. If the thickness of the covering layer is too small (such as, less than 20µm), the covering effect is poor. If the thickness of the covering layer is too large (such as, more than 30µm), the covering layer is brittle and has a poor adhesion.

As described above, in the present disclosure, the soft substrate 210 has a relatively small elastic modulus, and a good flexibility, the housing assembly 1000 has a large radian, and thus the appearance membrane 200 and the housing base 100 can be closely bonded, and the housing assembly 1000 has the diversified appearance. Moreover, the metallic luster effect can be achieved by the glossy silver layer 230 without coating a metal film, thereby improving the product expressiveness.

In a second aspect of the present disclosure, a method for fabricating a housing assembly is provided. In the present disclosure, the housing assembly fabricated by the method may be the housing assembly in the first aspect. In this way, the housing assembly fabricated by the method has all the features and advantages of the above-mentioned housing assembly, which will not be repeated here. In general, the housing assembly fabricated by the method has a large radian, and the appearance membrane and the housing base may be closely bonded, and thus the housing assembly has the diversified appearance, and may have the metallic luster effect without coating a metal film, thereby improving the product expressiveness.

In the present disclosure, as shown in FIG. 7, the method may include operations as follows.

In block S 100: providing a housing base.

In this operation, the housing base is provided. In the present disclosure, the housing base may be the above-mentioned housing base in the first aspect, such as, may be a glass base. The housing base has a bottom surface and a sidewall connected to the bottom surface, and a bending angle between the sidewall and the bottom surface is greater than 70 degrees.

In block S200: forming an appearance membrane, and bonding the appearance membrane on a side of the housing base.

In this operation, the appearance membrane is formed and bonded on the side of the housing base. In some embodiments of the present disclosure, as shown in FIG. 8, the formation of the appearance membrane may further include operations as follows.

In block S210: providing a soft substrate.

In this operation, the soft substrate is provided. In the present disclosure, the soft substrate is the above-mentioned soft substrate in the first aspect. The soft substrate includes at least one of a thermoplastic polyurethane, a polyvinyl chloride, and a thermoplastic elastomer, and the soft substrate 210 has an elastic modulus in a range of 800Mpa to 2000Mpa.

In this way, the soft substrate with the above-mentioned elastic modulus has a good flexibility, and may be closely bonded to the housing base with large bending angle without forming bubbles, thereby diversifying appearance of the housing assembly. In some embodiments, the soft substrate may have a thickness of 80µm to 100µm, and the soft substrate with the above-mentioned thickness may be well bonded to the housing base with a large bending angle.

In block S220: forming a color layer on a side of the soft substrate.

In this operation, the color layer is formed on a side of the soft substrate formed in the previous operation. In some embodiments of the present disclosure, a color ink composition may be applied on the side of the soft substrate by screen printing to form the color layer, to realize a diversified color on the soft substrate. Specifically, the color ink composition may be suitably selected by those skilled in the art according to color requirements. The color ink composition may include a color ink, a first curing agent, and a first diluent. In some embodiments of the present disclosure, the color of the color ink is not specially limited, and may be selected by those skilled in the art, such as, may be black, white, pink, gold, silver, light blue, purple or red. Specifically, the color ink composition may include 5% to 30% by weight of the first curing agent, and 5% to 20% by weight of the first diluent. In this way, the color and the light transmittance of the color layer may be conveniently adjusted to obtain the desired color effect.

Specifically, the color ink composition may be placed on a screen of an automatic screen printing machine, and be printed on the soft substrate (such as a TPU film) by spreading the color ink composition. The screen may have a mesh number from 280 to 420 mesh. The mesh number of the screen is the number of holes per inch on the screen. The larger the mesh number of the screen is, the higher the fineness is.

Specifically, the formed color layer may have a light transmittance of 30% to 70%. In this way, the color layer with the above-mentioned light transmittance may be superimposed on a glossy silver layer formed in the following operation, and thus the housing assembly has a color effect and a metallic luster effect at the same time, and has a high luminance and an improved product expressiveness. Specifically, the color layer may have a thickness of 4µm to 12µm, and the appearance effect of the housing assembly may be further improved.

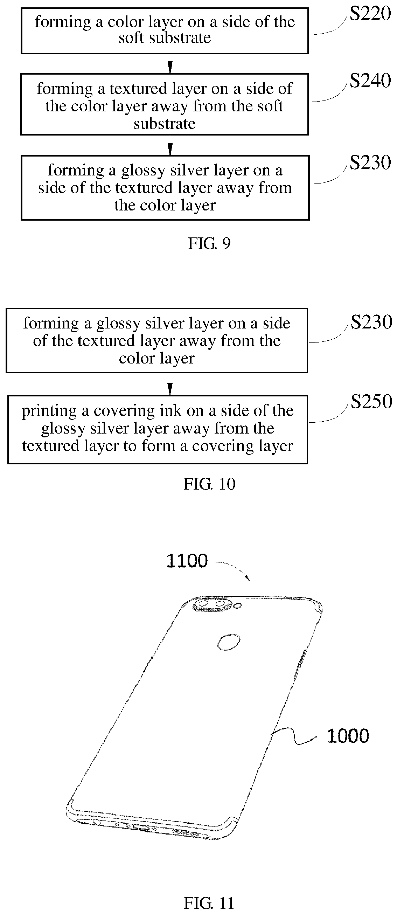

In some embodiments of the present disclosure, as shown in FIG. 9, after forming the color layer, the method may further include operations as follows.

In block S240: forming a textured layer on a side of the color layer away from the soft substrate.

In this operation, the textured layer is formed on the side of the color layer away from the soft substrate. In some embodiments of the present disclosure, the textured layer may be formed by UV transfer printing. As mentioned above, in order to achieve the metallic luster effect, various textures may be processed on a surface of the soft substrate (such as the TPU film). The textured layer may be superimposed on the glossy silver layer formed in the following operations to realize a diversified metallic luster effect. Specifically, a UV adhesive may be dispensed on an optical textured mold (master), and the soft substrate (such as the TPU substrate) may cover and be bonded on the master. The soft substrate and the master are pressed by a silicone roller with a pressure of 0.1 to 3Mpa to be bonded together. After the UV adhesive is cured, the textured mold (master) is separated and removed from the TPU substrate. The UV adhesive remains on the TPU substrate to obtain the desired texture. Specifically, the UV transfer printing may involve a UV curing energy of 1000mj/cm² to 1500mj/cm², such as 1200 mj/cm², 1300mj/cm² or 1400 mj/cm². Specifically, the textured layer may have a thickness of 6µm to 12µm. In this way, the textured layer with the above-mentioned thickness may be closely bonded to the glossy silver layer, and thus the housing assembly may exhibit the diversified metallic luster effect.

In block S230: forming a glossy silver layer on a side of the color layer away from the soft substrate.

In this operation, the glossy silver layer is formed on a side of the color layer that has been formed in the previous operation away from the soft substrate, or on a side of the textured layer that has been formed in the previous operation away from the color layer. In some embodiments of the present disclosure, the method of forming the glossy silver layer and the formed glossy silver layer may be the same as the above-mentioned ones, and will not be repeated here. For example, the glossy silver layer may be formed by screen printing glossy silver ink, which is easy to be operated and controlled, thus further diversifying the appearance of the housing assembly. Specifically, a glossy silver ink composition may be applied on a side of the textured layer away from the color layer by screen printing. Specifically, the components of the glossy silver ink composition are not specially limited, and the glossy silver ink composition may include a glossy silver ink, a second curing agent, and a second diluent, wherein the glossy silver ink composition may include 1% to 10% by weight of the second curing agent, and 2% to 5% by weight of the second diluent. In this way, the formed glossy silver layer may have a good metallic luster effect, the fabricated housing assembly may have a high luminance, a diversified appearance and an improved expressiveness. For example, the housing assembly may have a luminance L of 60 to 80. Specifically, the glossy silver ink composition may be placed on a screen of an automatic screen printing machine, and be printed on the textured layer by spreading the glossy silver ink composition. The glossy silver ink may be commercially available. The mesh number of the screen (the number of holes per inch on the screen) may range from 280 to 420. The larger the mesh number of the screen is, the higher the fineness is. Specifically, the formed glossy silver layer may have a thickness of 2µm to 8µm. The glossy silver layer with the above-mentioned thickness may make the housing assembly have a good metallic luster effect, and a high luminance.

In some embodiments of the present disclosure, as shown in FIG. 10, after forming the glossy silver layer, the method may further include operations as follows.

In block S250: printing a covering ink on a side of the glossy silver layer away from the textured layer to form a covering layer.

In this operation, the covering ink is printed on the side of the glossy silver layer away from the textured layer to form the covering layer. In some embodiments of the present disclosure, the covering layer may be the above-mentioned covering layer in the first aspect. For example, the converting layer may have a light transmittance of equal to or less than 1%, and a thickness of 20µm to 30µm. Specifically, the covering ink, such as black ink or white ink, may be printed multiple times on the side of the glossy silver layer away from the textured layer (if the thickness of the covering layer formed by one-time printing is too large, the covering layer may have a high brittleness, a poor adhesion and a poor performance), to form the covering layer. In this way, the covering layer is formed by printing and curing the covering ink for multiple times, which may avoid light leakage of the covering layer, and further improve the use performance of the housing assembly as fabricated. Specifically, the covering layer of a thickness of 5µm to 8µm may be formed upon each printing, and the covering layer may have a total thickness of 20µm to 30µm after multiple-times of the printings. The covering layer with the above-mentioned thickness has a good light-shielding effect and an improved adhesion, which may protect the screen printed glossy silver layer from being corroded. Specifically, the mesh number of the screen for printing the covering ink may range from 350 to 420 mesh. On the above basis, the housing assembly fabricated by the method has a large radian, the appearance membrane and the housing base may be closely bonded together, and the housing assembly may have a diversified appearance. Moreover, the metallic luster effect can be achieved without coating a metal film, thereby improving expressiveness of the product.

In a third aspect of the present disclosure, an electronic device is provided. In the present disclosure, as shown in FIG. 11, the electronic device 1100 includes: the above-mentioned housing assembly 1000 in the first aspect or the housing assembly fabricated by the above-mentioned method in the second aspect, a mainboard, a memory and a screen (not shown). An accommodating space is defined by the housing assembly 1000, and the appearance membrane (not shown) of the housing assembly 1000 may face toward an interior of the electronic device. The mainboard and the memory are located inside the accommodating space. The screen is located on a top of the housing assembly 1000 and connected to the mainboard. In this way, the electronic device 1100 has all the features and advantages of the above-mentioned housing assembly 1000 or the above-mentioned method for fabricating the housing assembly, which will not be repeated here. In general, the electronic device 1100 has a diversified appearance and an improved product expressiveness.

For example, the electronic device may be any type of various mobile or portable computer system devices which are able to realize wireless communication. Specifically, the electronic device may be a mobile phone or a smart phone (e.g., a phone based on iPhone TM or Android TM), a portable game device (e.g. Nintendo DS TM, PlayStation Portable TM, Gameboy Advance TM, iPhone TM), a laptop computer, a personal digital assistant (PDA), a portable internet terminal device, a music player and a storage device or other handset device (e.g., a watch, an in-ear earphone, a pendant, a headphone, etc.). The electronic device may also be other wearable devices (e.g., electronic glasses, electronic clothes, electronic bracelets, electronic necklaces, electronic tattoos, electronic equipments, smart watches and head-mounted devices (HMD)).

The electronic device may be any one of a plurality of electronic devices including, but not limited to, a cellular phone, a smart phone, other wireless communication device, a personal digital assistant, an audio player, other media player, a music recorder, a video recorder, a camera, other media recorder, radio, a medical equipment, a vehicle transportation equipment, a calculator, a programmable remote controller, a pager, a laptop computer, a desktop computer, a printer, a netbook computer, a personal digital assistant (PDA), a portable multimedia player (PMP), a motion picture expert group (MPEG-1 or MPEG-2) audio player 3 (MP3), a portable medical equipment, a digital camera or any combination thereof.

In some cases, the electronic device may perform various functions (e.g., playing music, showing video, storing pictures and transmitting/receiving telephone calls). If desired, the electronic device may be a cell phone, a media player, other handset devices, a wrist watch device, a pendant device, an earpiece device or other compact portable devices.

## Claims

1. A housing assembly (1000), comprising:
a housing base (100) being transparent and having a bottom surface (110) and a sidewall (120) connected to the bottom surface (110), wherein a bending angle between the sidewall (120) and the bottom surface (110) is greater than 70 degrees; and
an appearance membrane (200) located on a side of the housing base (100) and comprising:
a soft substrate (210), and
a glossy silver layer (230) located on a side of the soft substrate (210),
**characterized in that** the soft substrate (210) has an elastic modulus in a range of 800Mpa to 2000Mpa, and the soft substrate (210) comprises at least one of a thermoplastic polyurethane, a polyvinyl chloride, and a thermoplastic elastomer.

2. The housing assembly (1000) according to claim 1, wherein the soft substrate (210) has a thickness of 80µm to 100µm.

3. The housing assembly (1000) according to claim 1 or 2, further comprising a color layer (220) located between the soft substrate (210) and the glossy silver layer (230), wherein the color layer (220) has any one or both of
a light transmittance of 30% to 70%, and
a thickness of 4µm to 12µm.

4. The housing assembly (1000) according to any one of claims 1 to 3, wherein the glossy silver layer (230) has a thickness of 2µm to 8µm.

5. The housing assembly (1000) according to claim 3 or 4, wherein the appearance membrane (200) further comprises a textured layer (240), preferably having a thickness of 6µm to 12µm, located between the color layer (220) and the glossy silver layer (230).

6. The housing assembly (1000) according to any one of claims 3 to 5, wherein the appearance membrane (200) further comprises a covering layer (250) located on a side of the glossy silver layer (230) away from the color layer (220), wherein the covering layer (250) has any one or both of
a light transmittance of equal to or less than 1%, and
a thickness of 20µm to 30µm.

7. The housing assembly (1000) according to any one of claims 1 to 6, wherein the housing assembly (1000) has a luminance L of 60 to 80.

8. A method for fabricating a housing assembly (1000), comprising the steps of
providing (S100) a housing base (100) being transparent and having a bottom surface (110) and a sidewall (120) connected to the bottom surface (110), wherein a bending angle between the sidewall (120) and the bottom surface (110) is greater than 70 degrees; and
forming (S200) an appearance membrane (200), and bonding the appearance membrane (200) on a side of the housing base (100), wherein said forming the appearance membrane (200) comprising the steps of
providing (S210) a soft substrate (210), and
forming a glossy silver layer (230) on a side of the soft substrate (210),
**characterized in that** the soft substrate (210) has an elastic modulus in a range of 800Mpa to 2000Mpa, and the soft substrate (210) comprises at least one of a thermoplastic polyurethane, a polyvinyl chloride, and a thermoplastic elastomer.

9. The method according to claim 8, wherein the soft substrate (210) has a thickness of 80µm to 100µm.

10. The method according to claim 8 or 9, wherein before forming the glossy silver layer (230), said forming the appearance membrane (200) further comprises the step of
forming (S220) a color layer (220) on a side of the soft substrate (210),
wherein said forming (S220) the color layer (220) comprises the step of
applying a color ink composition on the side of the soft substrate (210) by screen printing to form the color layer (220),
preferably the color ink composition comprises a color ink, a first curing agent, and a first diluent, wherein a content of the first curing agent is 5% to 30% by weight, and a content of the first diluent is 5% to 20% by weight.

11. The method according to claim 10, wherein after forming (S220) the color layer (220) and before forming the glossy silver layer (230), the method further comprises the step of
forming (S240) a textured layer (240) on a side of the color layer (220) away from the soft substrate (210), preferably by UV transfer printing with a UV curing energy of 1000mj/cm² to 1500mj/cm².

12. The method according to claim 11, wherein said forming the glossy silver layer (230) comprises the step of
applying a glossy silver ink composition on a side of the textured layer (240) away from the color layer (220) by screen printing,
preferably the glossy silver ink composition comprises a glossy silver ink, a second curing agent and a second diluent, wherein a content of the second curing agent is 1% to 10% by weight, and a content of the second diluent is 2% to 5% by weight.

13. The method according to claim 11 or 12, wherein after forming the glossy silver layer (230), the method further comprises the step of
printing (S250) a covering ink on a side of the glossy silver layer (230) away from the textured layer (240) to form a covering layer (250) having a light transmittance of equal to or less than 1%.

14. The method according to claim 13, wherein said forming the covering layer (250) further comprises the step of
printing the covering ink for multiple times on the side of the glossy silver layer (230) away from the textured layer (240), the covering layer (250) with a thickness of 5µm to 8µm being formed after each printing.

15. An electronic device (1100), comprising:
the housing assembly (1000) according to any one of claims 1 to 7, the housing assembly (1000) defining an accommodating space, and the appearance membrane (200) of the housing assembly (1000) facing toward an interior of the electronic device;
a mainboard and a memory, located inside the accommodating space; and
a screen, located on a top of the housing assembly (1000) and connected to the mainboard.

## Patentansprüche

1. Gehäuseanordnung (1000), umfassend:
eine Gehäusebasis (100), die transparent ist und eine Bodenfläche (110) und eine Seitenwand (120) aufweist,
welche mit der Bodenfläche (110) verbunden ist, wobei ein Biegewinkel zwischen der Seitenwand (120) und der Bodenfläche (110) größer als 70 Grad ist; und
eine Erscheinungsbildmembran (200), die sich auf einer Seite der Gehäusebasis (100) befindet und umfasst:
ein weiches Substrat (210), und
eine glänzende Silberschicht (230), die sich auf einer Seite des weichen Substrats (210) befindet,
**dadurch gekennzeichnet, dass** das weiche Substrat (210) einen Elastizitätsmodul im Bereich von 800 MPa bis 2000 MPa hat, und das weiche Substrat (210) mindestens eines von einem thermoplastischen Polyurethan, einem Polyvinylchlorid und einem thermoplastischen Elastomer umfasst.

2. Gehäuseanordnung (1000) nach Anspruch 1, wobei das weiche Substrat (210) eine Dicke von 80 µm bis 100 µm hat.

3. Gehäuseanordnung (1000) nach Anspruch 1 oder 2, des Weiteren umfassend eine Farbschicht (220), die sich zwischen dem weichen Substrat (210) und der glänzenden Silberschicht (230) befindet, wobei die Farbschicht (220) ein oder beide der folgenden aufweist:
eine Lichtdurchlässigkeit von 30 % bis 70 %, und
eine Dicke von 4 µm bis 12 µm.

4. Gehäuseanordnung (1000) nach einem der Ansprüche 1 bis 3, wobei die glänzende Silberschicht (230) eine Dicke von 2 µm bis 8 µm hat.

5. Gehäuseanordnung (1000) nach Anspruch 3 oder 4, wobei die Erscheinungsbildmembran (200) des Weiteren eine texturierte Schicht (240) umfasst, vorzugsweise mit einer Dicke von 6 µm bis 12 µm, die sich zwischen der Farbschicht (220) und der glänzenden Silberschicht (230) befindet.

6. Gehäuseanordnung (1000) nach einem der Ansprüche 3 bis 5, wobei die Erscheinungsbildmembran (200) des Weiteren eine Abdeckschicht (250) umfasst, die sich auf einer Seite der glänzenden Silberschicht (230) befindet, die von der Farbschicht (220) weg weist, wobei die Abdeckschicht (250) eine oder beide der folgenden aufweist:
eine Lichtdurchlässigkeit gleich oder kleiner als 1 %, und
eine Dicke von 20 µm bis 30 µm.

7. Gehäuseanordnung (1000) nach einem der Ansprüche 1 bis 6, wobei die Gehäuseanordnung (1000) eine Leuchtdichte L von 60 bis 80 aufweist.

8. Verfahren zur Fertigung einer Gehäuseanordnung (1000), umfassend die Schritte:
Bereitstellen (S100) einer Gehäusebasis (100), die transparent ist und eine Bodenfläche (110) und eine Seitenwand (120) aufweist, welche mit der Bodenfläche (110) verbunden ist, wobei ein Biegewinkel zwischen der Seitenwand (120) und der Bodenfläche (110) größer als 70 Grad ist; und
Bilden (S200) einer Erscheinungsbildmembran (200), und Bonden der Erscheinungsbildmembran (200) an eine Seite der Gehäusebasis (100), wobei das Bilden der Erscheinungsbildmembran (200) die Schritte umfasst:
Bereitstellen (S210) eines weichen Substrats (210), und
Bilden einer glänzenden Silberschicht (230) auf einer Seite des weichen Substrats (210),
**dadurch gekennzeichnet dass** das weiche Substrat (210) einen Elastizitätsmodul im Bereich von 800 MPa bis 2000 MPa hat, und das weiche Substrat (210) mindestens eines von einem thermoplastischen Polyurethan, einem Polyvinylchlorid und einem thermoplastischen Elastomer umfasst.

9. Verfahren nach Anspruch 8, wobei das weiche Substrat (210) eine Dicke von 80 µm bis 100 µm hat.

10. Verfahren nach Anspruch 8 oder 9, wobei das Bilden der Erscheinungsbildmembran (200) vor dem Bilden der glänzenden Silberschicht (230) des Weiteren den Schritt umfasst:
Bilden (S220) einer Farbschicht (220) auf einer Seite des weichen Substrats (210),
wobei das Bilden (S220) der Farbschicht (220) den Schritt umfasst:
Aufbringen einer Farbtintenzusammensetzung auf die Seite des weichen Substrats (210) durch Siebdruck, um die Farbschicht (220) zu bilden,
wobei die Farbtintenzusammensetzung vorzugsweise eine Farbtinte, ein erstes Härtungsmittel und ein erstes Verdünnungsmittel umfasst, wobei ein Gehalt des ersten Härtungsmittels 5 Gew.% bis 30 Gew.% beträgt, und ein Gehalt des ersten Verdünnungsmittels 5 Gew.% bis 20 Gew.% beträgt.

11. Verfahren nach Anspruch 10, wobei das Verfahren nach dem Bilden (S220) der Farbschicht (220) und vor dem Bilden der glänzenden Silberschicht (230) des Weiteren den Schritt umfasst:
Bilden (S240) einer texturierten Schicht (240) auf einer Seite der Farbschicht (220), die von dem weichen Substrat (210) weg weist, vorzugsweise durch UV-Transferdruck mit einer UV-Härtungsenergie von 1000 mJ/cm² bis 1500 mJ/cm².

12. Verfahren nach Anspruch 11, wobei das Bilden der glänzenden Silberschicht (230) den Schritt umfasst:
Aufbringen einer glänzenden Silbertintenzusammensetzung auf eine Seite der texturierten Schicht (240), die von der Farbschicht (220) weg weist, durch Siebdruck,
wobei die glänzende Silbertintenzusammensetzung vorzugsweise eine glänzende Silbertinte, ein zweites Härtungsmittel und ein zweites Verdünnungsmittel umfasst, wobei ein Gehalt des zweiten Härtungsmittels 1 Gew.% bis 10 Gew.% beträgt, und ein Gehalt des zweiten Verdünnungsmittels 2 Gew.% bis 5 Gew.% beträgt.

13. Verfahren nach Anspruch 11 oder 12, wobei das Verfahren nach dem Bilden der glänzenden Silberschicht (230) des Weiteren den Schritt umfasst:
Drucken (S250) einer Abdecktinte auf eine Seite der glänzenden Silberschicht (230), die von der texturierten Schicht (240) weg weist, um eine Abdeckschicht (250) mit einer Lichtdurchlässigkeit gleich oder kleiner als 1 % zu bilden.

14. Verfahren nach Anspruch 13, wobei das Bilden der Abdeckschicht (250) des Weiteren den Schritt umfasst:
Drucken der Abdecktinte mehrfach auf die Seite der glänzenden Silberschicht (230), die von der texturierten Schicht (240) weg weist, wobei die Abdeckschicht (250) mit einer Dicke von 5 µm bis 8 µm nach jedem Drucken gebildet wird.

15. Elektronische Vorrichtung (1100), umfassend:
die Gehäuseanordnung (1000) nach einem der Ansprüche 1 bis 7, wobei die Gehäuseanordnung (1000) einen Unterbringungsraum definiert und die Erscheinungsbildmembran (200) der Gehäuseanordnung (1000) zu einem Innenbereich der elektronischen Vorrichtung weist;
eine Hauptplatine und einen Speicher, die sich innerhalb des Unterbringungsraums befinden; und
einen Bildschirm, der sich oben auf der Gehäuseanordnung (1000) befindet und mit der Hauptplatine verbunden ist.

## Revendications

1. Ensemble boîtier (1000), comprenant :
une base de boîtier (100) transparente et ayant une surface inférieure (110) et une paroi latérale (120) reliée à la surface inférieure (110), un angle de courbure entre la paroi latérale (120) et la surface inférieure (110) étant supérieur à 70 degrés ; et
une membrane d'aspect (200) située sur un côté de la base du boîtier (100) et comprenant :
un substrat souple (210), et
une couche d'argent brillante (230) située sur un côté du substrat souple (210),
**caractérisé en ce que** le substrat souple (210) a un module d'élasticité compris entre 800 Mpa et 2000 Mpa, et **en ce que** le substrat souple (210) comprend au moins l'un parmi un polyuréthane thermoplastique, un chlorure de polyvinyle et un élastomère thermoplastique.

2. Ensemble boîtier (1000) selon la revendication 1, le substrat souple (210) ayant une épaisseur de 80 um à 100 um.

3. Ensemble boîtier (1000) selon la revendication 1 ou 2, comprenant en outre une couche de couleur (220) située entre le substrat souple (210) et la couche d'argent brillante (230), la couche de couleur (220) présentant l'une quelconque des caractéristiques suivantes ou les deux :
une transmission de la lumière de 30 % à 70 %, et
une épaisseur de 4 um à 12 um.

4. Ensemble boîtier (1000) selon l'une quelconque des revendications 1 à 3, la couche d'argent brillante (230) ayant une épaisseur de 2 um à 8 um.

5. Ensemble boîtier (1000) selon la revendication 3 ou 4, la membrane d'aspect (200) comprenant en outre une couche texturée (240), ayant de préférence une épaisseur de 6 um à 12 um, située entre la couche de couleur (220) et la couche d'argent brillante (230).

6. Ensemble boîtier (1000) selon l'une quelconque des revendications 3 à 5, la membrane d'aspect (200) comprenant en outre une couche de recouvrement (250) située sur une face de la couche d'argent brillante (230) à l'écart de la couche de couleur (220), la couche de recouvrement (250) présentant l'une quelconque des caractéristiques suivantes ou les deux :
une transmission de la lumière égale ou inférieure à 1 %, et
une épaisseur de 20 µm à 30 µm.

7. Ensemble boîtier (1000) selon l'une quelconque des revendications 1 à 6, l'ensemble boîtier (1000) ayant une luminance L de 60 à 80.

8. Procédé de fabrication d'un ensemble boîtier (1000), comprenant les étapes suivantes :
la fourniture (S100) d'une base de boîtier (100) transparente et ayant une surface inférieure (110) et une paroi latérale (120) reliée à la surface inférieure (110), un angle de courbure entre la paroi latérale (120) et la surface inférieure (110) étant supérieur à 70 degrés ; et
la formation (S200) d'une membrane d'aspect (200), et le collage de la membrane d'aspect (200) sur un côté de la base du boîtier (100), ladite formation de la membrane d'aspect (200) comprenant les étapes suivantes :
fourniture (S210) d'un substrat souple (210), et
formation d'une couche d'argent brillante (230) sur une face du substrat souple (210),
**caractérisé en ce que** le substrat souple (210) a un module d'élasticité compris entre 800 Mpa et 2000 Mpa, et **en ce que** le substrat souple (210) comprend au moins l'un parmi un polyuréthane thermoplastique, un chlorure de polyvinyle et un élastomère thermoplastique.

9. Procédé selon la revendication 8, le substrat souple (210) ayant une épaisseur de 80 µm à 100 µm.

10. Procédé selon la revendication 8 ou 9, avant de former la couche d'argent brillante (230), ladite formation de la membrane d'aspect (200) comprenant en outre l'étape de :
formation (S220) d'une couche de couleur (220) sur une face du substrat souple (210),
ladite formation (S220) de la couche de couleur (220) comprenant l'étape de :
application d'une composition d'encre de couleur sur la face du substrat souple (210) par sérigraphie pour former la couche de couleur (220),
de préférence, la composition d'encre de couleur comprenant une encre de couleur, un premier agent de durcissement et un premier diluant, une teneur du premier agent de durcissement étant de 5 % à 30 % en poids et une teneur du premier diluant étant de 5 % à 20 % en poids.

11. Procédé selon la revendication 10, après avoir formé (S220) la couche de couleur (220) et avant de former la couche d'argent brillante (230), le procédé comprenant en outre l'étape de :
formation (S240) d'une couche texturée (240) sur une face de la couche de couleur (220) à l'écart du substrat souple (210), de préférence par impression par transfert UV avec une énergie de durcissement UV de 1000mj/cm² à 1500mj/cm².

12. Procédé selon la revendication 11, ladite formation de la couche d'argent brillante (230) comprenant l'étape de :
application d'une composition d'encre argentée brillante sur une face de la couche texturée (240) à l'écart de la couche de couleur (220) par sérigraphie,
de préférence, la composition d'encre argentée brillante comprenant une encre argentée brillante, un second agent de durcissement et un second diluant, une teneur du second agent de durcissement étant comprise entre 1 % et 10 % en poids, et une teneur du second diluant étant comprise entre 2 % et 5 % en poids.

13. Procédé selon la revendication 11 ou 12, après avoir formé la couche d'argent brillante (230), le procédé comprenant en outre l'étape de :
impression (S250) d'une encre de couverture sur une face de la couche d'argent brillante (230) à l'écart de la couche texturée (240) pour former une couche de couverture (250) ayant une transmission de la lumière égale ou inférieure à 1 %.

14. Procédé selon la revendication 13, ladite formation de la couche de recouvrement (250) comprenant en outre l'étape de :
impression de l'encre de recouvrement plusieurs fois sur la face de la couche d'argent brillante (230) à l'écart de la couche texturée (240), la couche de recouvrement (250) d'une épaisseur de 5 um à 8 um étant formée après chaque impression.

15. Dispositif électronique (1100), comprenant :
l'ensemble boîtier (1000) selon l'une quelconque des revendications 1 à 7, l'ensemble boîtier (1000) définissant un espace de logement, et la membrane d'aspect (200) de l'ensemble boîtier (1000) étant orientée vers un intérieur du dispositif électronique ;
une carte mère et une mémoire, situées à l'intérieur de l'espace de logement ; et
un écran, situé sur le dessus du boîtier (1000) et connecté à la carte mère.
